# EUROPEAN PATENT SPECIFICATION

(11) **EP 0 236 811 B1**
(45) Date of publication and mention of the grant of the patent: **13.04.1994**
(21) Application number: 87102343.8
(22) Date of filing: 19.02.1987
(51) Int. Cl.: H01L 29/70, H01L 21/225, H01L 21/74, H01L 21/76

(54) **Method of manufacturing semiconductor device**
Verfahren zur Herstellung eines Halbleiterbauelementes
Procédé pour la fabrication d'un dispositif à semi-conducteur

(30) Priority: 07.03.1986 JP 49910/86
(43) Date of publication of application: 16.09.1987
(73) Proprietor: KABUSHIKI KAISHA TOSHIBA, Kawasaki-shi, Kanagawa-ken 210 (JP)
(72) Inventor: Ito, Takao c/o Patent Division, Minato-ku Tokyo 105 (JP)
(74) Representative: Hansen, Bernd, Dr. Dipl.-Chem.

(56) References cited:
- EP-A- 0 071 204
- EP-A- 0 107 902
- EP-A- 0 140 369
- US-A- 4 391 033
- IEEE JOURNAL ON SELECTED AREAS IN COMMUNICATIONS, vol. SAC-4, no. 1, January 1986, pages 24-31, New York, USA ; K. WOERNER et al. : "High-Speed Si-Bipolar and GaAs Technologies".
- IBM TECHNICAL DISCLOSURE BULLETIN, vol. 25, no. 5, October 1982, pages 2288-2291, New York, USA ; N.G. ANANTHA et al. : "Method of forming polysilicon-filled isolation Regions in an Integrated circuit device".
- IBM TECHNICAL DISCLOSURE BULLETIN, vol. 21, no. 5, October 1978, pages 1868, 1869, New York, USA ; T.A. BARTUSH et al. : "Dielectric isolation planarization".

## Description

The present invention relates to a method of manufacturing a semiconductor device and, more particularly, to an improvement in a method for forming insulating layers for an inter-element isolation.

A p-n junction isolation method is the oldest technique of electrically isolating elements in the manufacture of semiconductor integrated circuits. Recently, an isolation method utilizing a thick oxide film formed by selectively oxidizing a semiconductor substrate has been widely used. The oxide film isolation method is called a recessed oxide method, or an isoplanar method, and can reduce an area of an isolation region and a parasitic capacitance advantageously as compared with the p-n junction isolation method. For this reason, this method is used not only for inter-element isolation but also for base-collector isolation in a bipolar transistor.

However, the above selective oxidation isolation method requires a long time for oxidation in an isolation step. In addition, the selective oxidation forms a bird's head or a bird's beak. It is well known that the above problems are serious obstacles to further improvement in packing density because elements are highly miniaturized today.

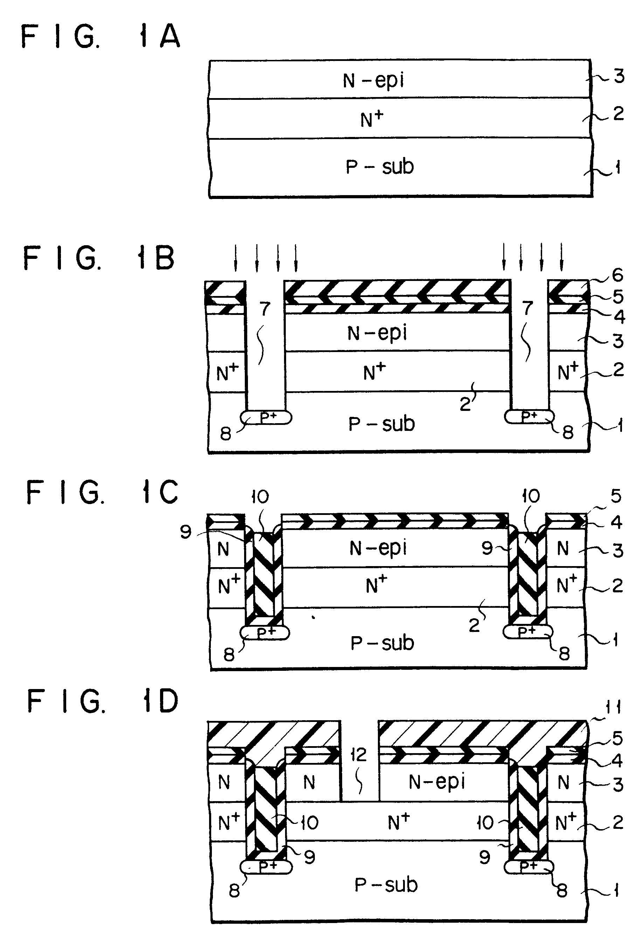

Various methods for solving the above problems have been proposed. In a method especially effective for high packing density, a groove is formed in an isolation region of a semiconductor layer by anisotropic etching such as reactive ion etching and an insulating material such as an oxide film is buried in this groove to isolate elements. For example, such a method is disclosed in Japanese Patent Disclosure (Kokai) No. 59-147445 and will be described below with reference to Figs. 1A to 1F.

In this method, as shown in Fig. 1A, n⁺-type impurity layer 2 is formed on a surface of p-type semiconductor substrate 1 and then n-type epitaxial silicon layer 3 is grown thereon.

Subsequently, as shown in Fig. 1B, thermal oxide film 4, Si₃N₄ film 5, and SiO₂ film 6 are sequentially deposited on the surface of layer 3 and then selectively etched to form an opening at a position in which an inter-element isolation region is to be formed. Subsequently, reactive ion etching is selectively performed to the resultant structure using the deposited films as etching masks to form deep grooves 7 dividing n⁺-type impurity layer 2 in inter-element isolated regions, as shown in Fig. 1B. Divided layers 2 are used as buried collector regions of bipolar transistors. Thereafter, boron is ion-implanted in the resultant structure using the deposited films as blocking masks to form p⁺-type inversion preventing regions 8 in the bottoms of grooves 7.

Film 6 is then removed and the resultant structure is thermally oxidized to form thermal oxide film 9 covering wall surfaces of grooves 7, as shown in Fig. 1C. Subsequently, polycrystalline silicon layer 10 is deposited until grooves 7 are completely buried. After coating with a photoresist to flatten the surface, etching is performed under the conditions in which an etching rate of polycrystalline silicon layer is substantially the same as that of the photoresist, in order to leave layer 10 only inside grooves 7, as shown in Fig. 1C.

Then, as shown in Fig. 1D, photoresist layer 11 having an opening on a base-collector isolation region is formed. Subsequently, films 4 and 5 and layer 3 are selectively etched by a reactive ion-etching (RIE) method using layer 11 as an etching mask to form groove 12 which reaches n⁺-type buried region 2.

After removing layer 11, as shown in Fig. 1E, thermal oxide film 9a covering inner walls of groove 12 is formed in the same manner as described above and then polycrystalline silicon layer 10a is buried in groove 12. Then, exposed surfaces of layers 10 and 10a are oxidized to form oxide films 13.

Subsequently, as shown in Fig. 1F, n⁺-type collector contact, p-type base, and n⁺-type emitter regions 14, 15, and 16 respectively, are formed and then collector, base, and emitter electrodes 17, 18, and 19 respectively, are formed to complete the bipolar semiconductor device.

In the above method, sizes of an inter-element isolation and a base-collector isolation region can be reduced as small as is obtainable by lithography. Therefore, the above method is extremely effective for miniaturization and high packing density of elements.

In the above method, an inter-element isolation step and a base-collector isolation step have the following problems.

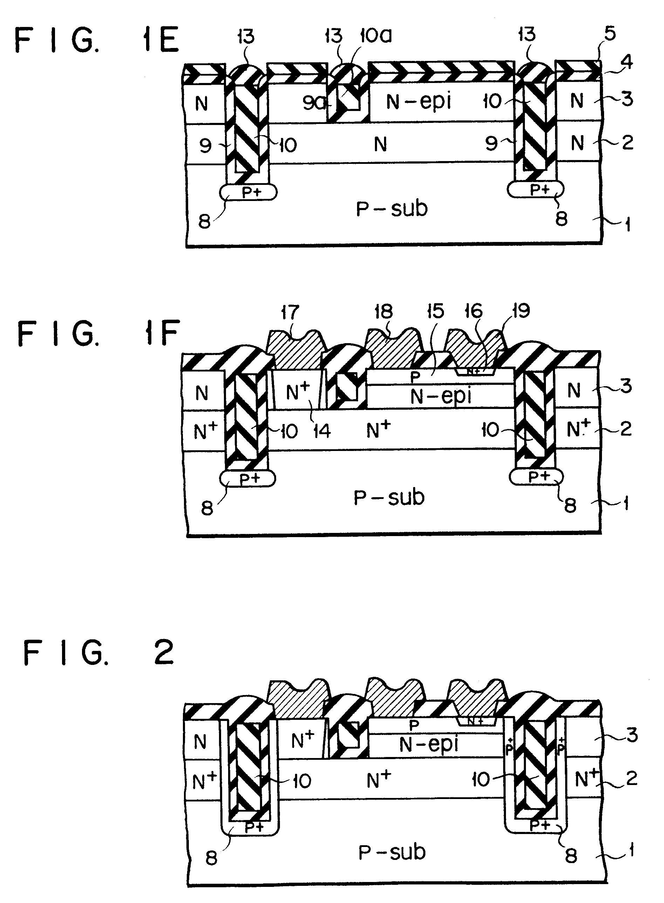

A problem in the inter-element isolation step will now be described. As shown in Fig. 1B, since grooves 7 are formed and then boron is ion-implanted into the bottom of grooves 7 to form an inversion-preventing layer, boron is also doped in the side walls of grooves 7. For this reason, a p⁺-type region is continuously formed around grooves 7, as shown in Fig. 2. As a result, not only a parasitic capacitance of base region 15 is increased but also region 15 and substrate 1 are short-circuited through p⁺-type region 8. In order to solve these problems, a method in which side wall surfaces of grooves 7 are covered with an insulating film and then ion implantation is performed has been proposed, but a step for forming an inversion-preventing layer becomes complex in this method.

A problem in the base-collector isolation step will now be described. Since groove 12 and grooves 7 for inter-element isolation are formed in different steps, a mask alignment error between the grooves occurs. Accordingly, the degree of miniaturization of elements is reduced by the margin corresponding to this error.

The article of K. Wörner et al., IEEE Journal on Selected Areas in Communications, Vol. SAC-4, No. 1, Jan. 1986, pages 24-31

It is an object of the present invention to provide a method for manufacturing semiconductor devices in which an inversion-preventing layer is formed only in a bottom of a groove formed by anisotropic etching without doping an impurity in its side walls when inter-element isolation is performed by burying an insulating material in the groove.

It is a second object of the present invention to simplify manufacturing steps and to miniaturize elements when a bipolar semiconductor device is manufactured, adopting an insulating material buried in a groove not only for inter-element isolation but also for base-collector isolation.

The object of the present invention is attained by a method comprising the steps of forming a high-concentration impurity region as disclosed in the claims.

An inversion-preventing layer located below a bottom of the first groove for inter-element isolation is formed prior to formation of the first groove. More specifically, the high-concentration impurity region of the first conductivity type serves as the inversion-preventing layer. As a result, ion implantation after formation of the first groove to form an inversion-preventing layer is not necessary, and undesirable doping into side walls of the first groove can be avoided.

In the object of the present invention, the high-concentration impurity region of the first conductivity type serving as an inversion-preventing layer together with the high-concentration buried region of the second conductivity type serving as a collector buried region are formed in an epitaxial layer by diffusion or by ion-implantation. Therefore, unlike a conventional method, the depth of the first groove for inter-element isolation need not be greater than but can be the same as that of the second groove for base-collector isolation. As a result, both grooves can be formed simultaneously, so the number of photolithographic processes can be reduced to miniaturize the device.

This invention can be more fully understood from the following detailed description when taken in conjunction with the accompanying drawings, in which:
Figs. 1A to 1F are sectional views showing a manufacturing process of a conventional semiconductor device;
Fig. 2 is a sectional view for explaining problems of the manufacturing process of the conventional semiconductor device shown in Figs. 1A to 1F;
Figs. 3A to 3E are sectional views showing a manufacturing process of a semiconductor device according to an embodiment of the present invention; and
Fig. 4 is a sectional view showing a semiconductor device.

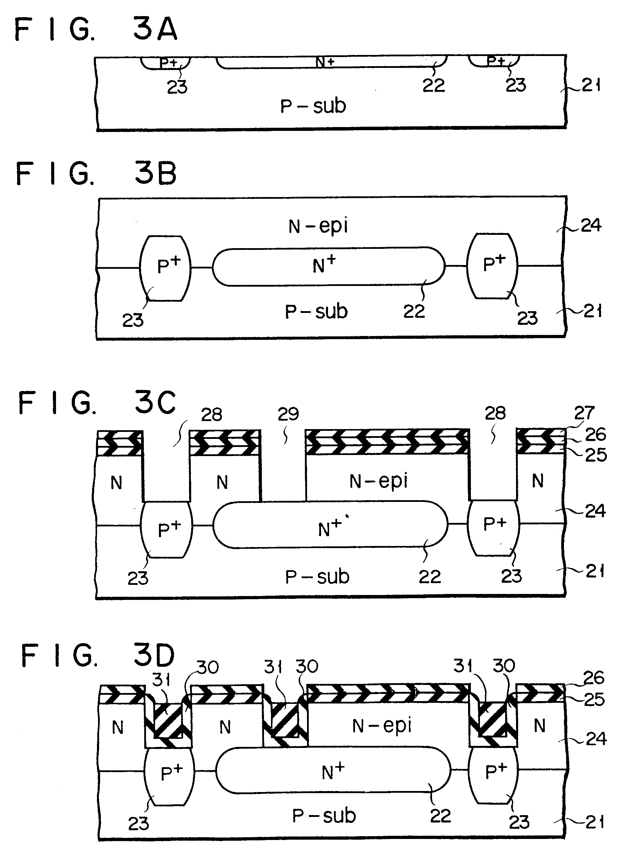

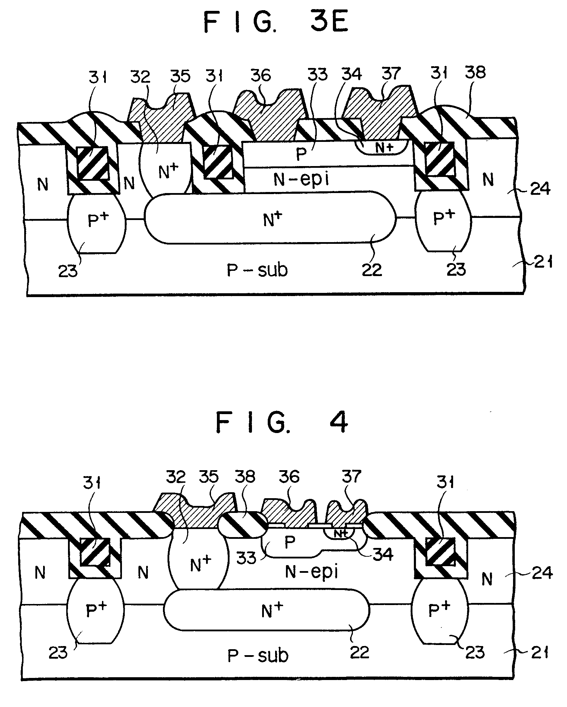

The present invention will now be described with reference to Figs. 3A to 3E.
(1) n⁺-type and p⁺-type impurities are doped in p-type silicon substrate 21 from its surface by a conventional method to form n⁺-type region 22 as a buried collector region in a prospective element formation region, and p⁺-type region 23 as an inversion-preventing layer in a prospective inter-element isolation region, respectively (Fig. 3A).
(2) n-type epitaxial silicon layer 24 is grown on silicon substrate 21 (Fig. 3B).
   In this thermal step, the impurities are diffused from regions 22 and 23 into substrate 21 and layer 24. As a result, expanded n⁺-type collector buried region 22 and p⁺-type buried region 23 are formed as shown in Fig. 3B. In addition, the diffusion coefficient of boron, usually used as a p-type impurity, is larger than that of antimony or arsenic used as an n-type impurity, so region 23 is thicker than region 22.
(3) A surface of layer 24 is thermally oxidized to form oxide film 25. Then, Si₃N₄ and SiO₂ films 26 and 27 are sequentially deposited to form insulating films by Chemical Vapor Deposition (CVD). Subsequently, lithography is performed using a photoresist to form rectangular sectional groove 28 which reaches region 23 in an inter-element isolation region and rectangular sectional groove 29 which reaches region 22 in a base-collector contact isolation region (Fig. 3C). The lithography step will be described in detail. A photoresist pattern having an opening at a predetermined position is formed and then films 27, 26, and 25 are sequentially etched using the photoresist pattern as masks. Subsequently, a so-called Reactive Ion Etching (RIE) is performed, using the opened insulating films as a mask to form grooves 28 and 29 having substantially vertical side walls. Note that generally, the depth of grooves 28 and 29 may be set in accordance with region 22.
(4) Film 27 is etched and removed with buffered hydrofluoric acid and then thermal oxidation is performed to form oxide film 30 covering the wall surfaces of grooves 28 and 29. Subsequently, polycrystalline silicon 31 is deposited by the CVD method until grooves 28 and 29 are completely buried, and a photoresist is coated to flatten the surfaces. Thereafter, layer 31 is etched under the conditions in which an etching rate of layer 31 is substantially the same as that of the photoresist in order to leave layer 31 only in grooves 28 and 29 and to bury them (Fig. 3D).
(5) A surface of film 31 is thermally oxidized using film 26 as an anti-oxidation film to form oxide film 38. Then, n⁺-type collector contact, p-type base, and n⁺-type emitter regions 32, 33, and 34 are formed, respectively. Thereafter, collector, base, and emitter electrodes 35, 36, and 37 are formed, respectively, to complete the device (Fig. 3E).

As described above, in this embodiment, p⁺-type region 23 serving as an inversion-preventing region is buried. Therefore, unlike a conventional method, an impurity need not be ion-implanted to form an inversion-preventing layer after inter-isolation region is grooved. For this reason, an impurity is prevented from being doped into side wall surfaces of the grooves without using a conventional complex step for forming a block film thereon, thereby easily solving problems of an increase in parasitic capacitance of a base region and a short circuit between region 33 and substrate 21.

Groove 28 for inter-element isolation need not extend through an epitaxial layer as a conventional groove for inter-element isolation does, but need only reach region 23. Therefore, since groove 28 can be shallower than a conventional groove, an etching time for forming the groove and the number of defects generated thereafter can be reduced.

In addition, groove 28 for inter-element isolation and groove 29 for base-collector isolation can be simultaneously formed in one lithographic process. Therefore, elements can be miniaturized, and the steps can be simplified because grooves having different depths need not be formed.

Note that in the above embodiment, the walls of grooves 28 and 29 are covered with a thermal oxide film and then a polycrystalline silicon layer is buried. However, the polycrystalline silicon layer may be buried after the walls are covered with an insulating film consisting of an Si₃N₄ film or a combination thereof with an oxide film.

In the manufacturing process of the above embodiment, since the thermal effect is not significant in a thermal step for inter-element isolation and for base region-collector contact region isolation, grooves 28 and 29 can be formed after or during formation of elements to perform inter-element isolation and base region-collector contact region isolation.

In addition, in the above embodiment, the present invention is applied to a vertical bipolar transistor, but it may be similarly applied to an inverted vertical transistor in an integrated-injection logic (I²L). In this case, an isolation region formed in an element region does not isolate between the base and collector contact regions but between the base and emitter contact regions.

Fig. 4 shows a structure of a vertical npn transistor whereby the base region-collector contact region isolation is performed by a conventional isoplanar method instead of forming groove 29. In Fig. 4, base region-collector contact region isolation is oxide film 38, having a conventional isoplanar structure.

In this case, any element, e.g., a diode, a diffusion resistor, or an integrated-injection logic (I²L), like a vertical bipolar transistor, may be formed in an element region.

## Claims

1. A method of manufacturing a semiconductor device comprising the steps of:
forming a high-concentration impurity region (23) of a first conductivity type in a portion, which serves as an inter-element isolation region, of a semiconductor substrate (21) of the first conductivity type and forming a high-concentration impurity region (22) of a second conductivity type in a portion thereof, which serves as an element region;
forming a semiconductor layer (24) of the second conductivity type on said semiconductor substrate (21) by an epitaxial-growth method and forming high-concentration buried regions (22, 23) of the first and second conductivity types obtained by extensions of said high-concentration impurity regions of the first and second conductivity types into both said semiconductor layer (24) of the second conductivity type and said semiconductor substrate (21) of the first conductivity type;
forming a first groove (28), which reaches said high-concentration impurity region (23) of the first conductivity type, for inter-element isolation by selective anisotropic etching of the semiconductor layer (24) of the second conductivity type and at the same time forming a second groove (29), which reaches said buried region (22) of the second conductivity type, for intra-element isolation of a vertical bipolar transistor;
forming inter-element and intra-element insulative isolation layers (31) by burying substantially insulative isolation material layers in the first and second grooves (28, 29); and
forming a collector region/collector contact region and a base region respectively in both sides of said intra-element insulative isolation layer formed in said second groove (29).

2. A method according to claim 1 , characterized in that said intra-element insulative isolation layer (31) serves as an isolastion layer between a base region and a collector contact region to form a vertical bipolar transistor in said element region.

3. A method according to claim 1 , characterized in that said intra-element insulative isolation layer (31) serves as an isolation layer between an emitter contact region and a base region to form an inverted vertical bipolar transistor in said element region.

4. A method according to claim 1 , characterized in that the step for forming said high-concentration buried regions (22, 23) of the first and second conductivity types adopts a method of diffusing said impurity regions (22, 23) of the first and second conductivity types into both said semiconductor layer (24) and said Semiconductor substrate (21) during epitaxial growth of said semiconductor layer (24).

5. A method according to claim 1 , characterized in that the step for forming said first and second grooves (28, 29) adopts a method of sequentially etching insulative films (25, 26 and 27) deposited on said semiconductor layer (24) to open them (28, 29) and performing a reactive ion etching treatment using said opened insulative films (25, 26 and 27) as a mask.

6. A method according to claim 5 , characterized in that said insulative films (25, 26 and 27) consist of SiO₂, Si₃N₄, and silicon oxide films.

7. A method according to claim 1 , characterized in that the step for forming said inter-element and intra-element insulative isolation layers (31) adopts a method of forming an insulative film (30) covering wall surfaces of said first and second grooves (28, 29), depositing said substantially insulative isolation layer (31) on the entire surfaces of said first and second grooves (28, 29) and flattening said surfaces, and then etching the entire flattened surface in order to leave said substantially insulative isolation material layer (31) only in said first and second grooves (28, 29).

8. A method according to claim 7 , characterized in that said insulative film (30) is a thermal oxide film.

9. A method according to claim 7 , characterized in that said substantially insulative isolation material layer (31) is a chemical vapor-deposited insulative layer.

10. A method according to claim 9 , characterized in that said chemical vapor-deposited insulative layer (31) is a polycrystalline silicon layer.

11. A method according to claim 7 , characterized in that a method of coating a photoresist on the entire surface of said substantially insulative isolation material layer (31) to flatten the surface, and etching said substantially insulative isolation material layer (31) and the photoresist under the conditions in which an etching rate of said substantially insulative isolation material layer (31) is substantially the same as that of the photoresist is used as a method of leaving said substantially insulative isolation material layer (31) only in said first and second grooves (28, 29).

## Patentansprüche

1. Verfahren zur Herstellung einer Halbleitervorrichtung, umfassend die Schritte:
Bildung eines hochkonzentrierten Verunreinigungsbereiches (23) eines ersten Leitfähigkeitstyps in einem Bereich, der als ein Zwischenelementisolationsbereich dient, von einem Halbleitersubstrat (21) des ersten Leitfähigkeitstyps, und Bildung eines hochkonzentrierten Verunreinigungsbereiches (22) eines zweiten Leitfähigkeitstyps in einem Bereich davon, der als ein Elementbereich dient;
Bildung einer Halbleiterschicht (24) des zweiten Leitfähigkeitstyps auf dem Halbleitersubstrat (21) durch ein epitaxiales Wachstumsverfahren und Bildung von hochkonzentrierten verborgenen Bereichen (22, 23) des ersten und des zweiten Leitfähigkeitstyps, erhalten durch Ausdehnungen der hochkonzentrierten Verunreinigungsbereiche des ersten und des zweiten Leitfähigkeitstyps sowohl in die Halbleiterschicht (24) des zweiten Leitfähigkeitstyps als auch des Halbleitersubstrates (21) des ersten Leitfähigkeitstyps;
Bildung einer ersten Rille (28), die den hochkonzentrierten Verunreinigungsbereich (23) des ersten Leitfähigkeitstyps erreicht, für die Interelementisolierung durch selektives anisotropes Ätzen der Halbleiterschicht (24) des zweiten Leitfähigkeitstyps, und zur gleichen Zeit Bildung einer zweiten Rille (29), die den verborgenen Bereich (22) des zweiten Leitfähigkeitstyps erreicht, für eine Intraelementisolierung eines vertikalen bipolaren Transistors;
Bildung von Interelement- und Intraelement-isolierenden Isolationsschichten (31) durch Verbergen von im wesentlichen isolierenden Isolationsmaterialschichten in der ersten und der zweiten Rille (28, 29); und
Bildung eines Kollektorbereiches/Kollektorkontaktbereiches bzw. eines Basisbereiches in beiden Seiten der isolierenden Intraelementisolationsschicht, die in der zweiten Rille (29) gebildet ist.

2. Verfahren nach Anspruch 1,
dadurch **gekennzeichnet**, daß
die isolierende Intraelementisolationsschicht (31) als eine Isolationsschicht zwischen einem Basisbereich und einem Kollektorkontaktbereich zur Bildung eines vertikalen bipolaren Transistors in dem Elementbereich dient.

3. Verfahren nach Anspruch 1,
dadurch **gekennzeichnet,** daß
die isolierende Intralementisolationsschicht (31) als eine Isolationsschicht zwischen einem Emitterkontaktbereich und einem Basisbereich dient, zur Bildung eines invertierten vertikalen bipolaren Transistors in dem Elementbereich.

4. Verfahren nach Anspruch 1,
dadurch **gekennzeichnet,** daß
der Schritt zur Bildung der hochkonzentrierten, verborgenen Bereiche (22, 23) des ersten und des zweiten Leitfähigkeitstyps ein Verfahren zum Diffundieren der Verunreinigungsbereiche (22, 23) des ersten und des zweiten Leitfähigkeitstyps sowohl in die Halbleiterschicht (24) als auch das Halbleitersubstrat (21) während des epitaxialen Wachstums der Halbleiterschicht (24) anwendet.

5. Verfahren nach Anspruch 1,
dadurch **gekennzeichnet,** daß
der Schritt zur Bildung der ersten und der zweiten Rille (28, 29) ein Verfahren zum aufeinanderfolgenden Ätzen von isolierenden Filmen (25, 26 und 27), die auf der Halbleiterschicht (24) niedergeschlagen sind, zur Öffnung dieser (28, 29) und zum Durchführen einer reaktiven Ionenätzbehandlung unter Verwendung der geöffneten isolierenden Filme (25, 26 und 27) als eine Maske anwendet.

6. Verfahren nach Anspruch 5,
dadurch **gekennzeichnet,** daß
die isolierenden Filme (25, 26 und 27) aus SiO₂, Si₃N₄ und Siliziumoxidfilmen bestehen.

7. Verfahren nach Anspruch 1,
dadurch **gekennzeichnet,** daß
der Schritt zur Bildung der isolierenden Interelement- und Intraelement-Isolationsschichten (31) ein Verfahren zur Bildung eines Isolationsfilmes (30), der Wandoberflächen der ersten und der zweiten Rille (28, 29) bedeckt, das Niederschlagen der im wesentlichen isolierenden Isolationsschicht (31) auf den gesamten Oberflächen der ersten und der zweiten Rille (28, 29) und das Ebnen der Oberflächen und das anschließende Ätzen der gesamten geebneten Oberfläche, damit die im wesentlichen isolierende Isolationsmaterialschicht (31) nur in der ersten und zweiten Rille (28, 29) gelassen wird, anwendet.

8. Verfahren nach Anspruch 7,
dadurch **gekennzeichnet,** daß
der Isolationsfilm (30) ein thermischer Oxidfilm ist.

9. Verfahren nach Anspruch 7,
dadurch **gekennzeichnet,** daß
die im wesentlichen isolierende Isolationsmaterialschicht (31) eine chemisch dampfniedergeschlagene Isolationsschicht ist.

10. Verfahren nach Anspruch 9,
dadurch **gekennzeichnet,** daß
die chemisch dampfniedergeschlagene Isolationsschicht (31) eine polykristalline Siliziumschicht ist.

11. Verfahren nach Ansruch 7,
dadurch **gekennzeichnet,** daß
ein Verfahren zum Beschichten eines Fotoresists auf der gesamten Oberfläche der im wesentlichen isolierenden Isolationsmaterialschicht (31) zum Ebnen der Oberfläche, und zum Ätzen der im wesentlichen isolierenden Isolationsmaterialschicht (31) und des Fotoresists unter den Bedingungen, daß eine Ätzrate der im wesentlichen isolierenden Isolationsmaterialschicht (31) im wesentlichen gleich ist wie die des Photoresists, als ein Verfahren zum Lassen der im wesentlichen isolierenden Isolationsmaterialschicht (31) nur in der ersten und zweiten Rille (28, 29), verwendet wird.

## Revendications

1. Procédé de fabrication d'un dispositif à semiconducteur, comprenant les étapes consistant à :
- former une région (23) d'impuretés à haute concentration d'un premier type de conductibilité dans une partie, qui sert de région d'isolation interéléments, d'un substrat de semiconducteur (21) du premier type de conductibilité, et former une région d'impuretés à haute concentration (22) d'un deuxième type de conductibilité dans une partie de celui-ci qui sert de région d'élément;
- former une couche de semiconducteur (24) du deuxième type de conductibilité sur ledit substrat de semiconducteur (21) par un procédé de croissance épitaxiale, et former des régions enterrées à haute concentration (22, 23) des premier et deuxième types de conductibilité obtenues par prolongement desdites régions d'impuretés à haute concentration des premier et deuxième types de conductibilité, tant dans ladite couche de semiconducteur (24) du deuxième type de conductibilité que dans ledit substrat de semiconducteur (21) du premier type de conductibilité;
- former une première rainure (28) qui atteint ladite région d'impuretés à haute concentration (23) du premier type de conductibilité, pour réaliser l'isolation interéléments, par attaque chimique anisotrope sélective de la couche de semiconducteur (24) du deuxième type de conductibilité et, en même temps, former une deuxième rainure (29) qui atteint ladite région enterrée (22) du deuxième type de conductibilité, pour réaliser l'isolation intra-élément d'un transistor bipolaire vertical;
- former des couches isolantes d'isolation interéléments et intra-élément (31) en enterrant des couches de matériau d'isolation sensiblement isolant dans les première et deuxième rainures (28, 29); et
- former une région de collecteur/région de contact de collecteur et une région de base, respectivement, des deux côtés de ladite couche isolante d'isolation intra-élément formée dans ladite deuxième rainure (29).

2. Procédé selon la revendication 1, caractérisé en ce que ladite couche isolante d'isolation intra-élément (31) sert de couche d'isolation entre une région de base et une région de contact de collecteur pour former un transistor bipolaire vertical dans ladite région d'élément.

3. Procédé selon la revendication 1, caractérisé en ce que ladite couche isolante d'isolation intra-élément (31) sert de couche d'isolation entre une région de contact d'émetteur et une région de base pour former un transistor bipolaire vertical inversé dans ladite région.

4. Procédé selon la revendication 1, caractérisé en ce que l'étape de formation desdites régions enterrées à haute concentration (22, 23) des premier et deuxième types de conductibilité utilise un procédé de diffusion desdites régions d'impuretés (22, 23) des premier et deuxième types de conductibilité tant dans ladite couche de semiconducteur (24) que dans ledit substrat de semiconducteur (21) pendant la croissance épitaxiale de ladite couche de semiconducteur (24).

5. Procédé selon la revendication 1, caractérisé en ce que l'étape de formation desdites première et deuxième rainures (28, 29) utilise un procédé d'attaque chimique séquentielle des films isolants (25, 26 et 27) déposés sur ladite couche de semiconducteur (24) pour les ouvrir (28, 29) et d'exécution d'un traitement d'attaque chimique par ions réactifs en utilisant lesdits films isolants ouverts (25, 26 et 27) comme masque.

6. Procédé selon la revendication 5, caractérisé en ce que lesdits films isolants (25, 26 et 27) sont des films de SiO₂, Si₃N₄, et d'oxyde de silicium.

7. Procédé selon la revendication 1, caractérisé en ce que l'étape de formation desdites couches isolantes d'isolation interéléments et intra-élément (31) utilise un procédé de formation d'un film isolant (30) couvrant les surfaces des parois desdites première et deuxième rainures (28, 29), de dépôt de ladite couche d'isolation sensiblement isolante (31) sur toutes les surfaces desdites première et deuxième rainures (28, 29) et d'aplanissement desdites surfaces, et ensuite, d'attaque chimique de toute la surface aplanie, afin de ne laisser ladite couche de matériau d'isolation sensiblement isolant (31) que dans lesdites première et deuxième rainures (28, 29).

8. Procédé selon la revendication 7, caractérisé en ce que ledit film isolant (30) est un film d'oxyde thermique.

9. Procédé selon la revendication 7, caractérisé en ce que ladite couche de matériau d'isolation sensiblement isolant (31) est une couche isolante formée par dépôt chimique en phase vapeur.

10. Procédé selon la revendication 9, caractérisé en ce que ladite couche isolante formée par dépôt chimique en phase vapeur (31) est une couche de silicium polycristallin.

11. Procédé selon la revendication 7, caractérisé en ce qu'un procédé pour étendre une couche de photorésist sur toute la surface de ladite couche de matériau d'isolation sensiblement isolant (31) pour aplanir la surface, et l'attaque chimique de ladite couche de matériau d'isolation sensiblement isolant (31) et le photorésist dans des conditions dans lesquelles une vitesse d'attaque chimique de ladite couche de matériau d'isolation sensiblement isolant (31) est sensiblement la même que celle du photorésist est utilisé comme procédé pour ne laisser ladite couche de matériau d'isolation sensiblement isolant (31) que sur lesdites première et deuxième rainures (28, 29).
